# FASCICULE DE BREVET EUROPEEN

(11) **EP 1 215 821 B1**
(45) Date de publication et mention de la délivrance du brevet: **19.01.2011**
(21) Numéro de dépôt: 01403056.3
(22) Date de dépôt: 29.11.2001
(51) Int. Cl.: H03M 5/14, H03M 13/31

(54) **Circuit pour garantir une fréquence minimale de transitions sur une liaison série**
Schaltkreis zur Sicherstellung einer minimalen Übergangsfrequenz für eine serielle Verbindung
Circuit for securing a minimal transition frequency on a serial link

(30) Priorité: 05.12.2000 FR 0015724
(43) Date de publication de la demande: 19.06.2002
(73) Titulaire: Bull SAS, 78340 Les Clayes-sous-Bois (FR)
(72) Inventeur: Boudry, Jean-Marie, 78650 Beynes (FR)

(56) Documents cités:
- EP-A- 0 751 522
- WO-A-98/34413
- US-A- 5 025 256
- US-A- 5 748 119

## Description

L'invention concerne un procédé de codage/décodage de données numériques transmises via des liaisons séries.

Elle concerne notamment un procédé de codage/décodage du type dit "8B/10B", la lettre "B" étant l'abréviation de "bit".

Elle s'applique plus particulièrement à des liaisons de type série sur de courtes distances et à haut débit.

L'invention concerne encore un dispositif pour la mise en oeuvre de ce procédé.

Dans le cadre de l'invention, le terme "données numériques" doit être compris dans son sens le plus général. Il inclut les notions de messages, mots binaires, etc., de façon générale, toutes séquences d'éléments binaires ou bits, dont la longueur est déterminée par l'application particulière envisagée.

Les transmissions du type précité se caractérisent notamment par le fait qu'elles ne sont pas associées à une horloge, contrairement, par exemple, aux transmissions de données numériques de type parallèle. Dans ce dernier cas, tous les bits composant un mot binaire par exemple, sont transmis en simultanéité, sur autant de liaisons physiques. Il s'ensuit que, dans le cas d'une liaison série, il est nécessaire d'adopter des mesures permettant de récupérer sur le récepteur des informations d'horloge.

Une autre contrainte qui doit généralement être respectée est le besoin de garantir un taux préétabli de transitions parmi tous les bits constituant une séquence binaire. De façon typique, on désire obtenir un taux moyen de 30 % pour une séquence de 1000 bits.

Une autre contrainte encore est relative à la fixation d'un paramètre particulier connu sous la dénomination anglo-saxonne "Maximum Run-Length" ("MRL") ou nombre de bits successifs maximum susceptibles de rester à une même valeur, "0" ou "1" logique.

Dans l'art connu, pour satisfaire simultanément ces exigences, on recourt le plus souvent à des codes dits "DC balanced", selon la terminologie anglo-saxonne, c'est-à-dire des codes n'induisant pas de composante continue, du moins sur un intervalle de temps préétabli.

Une des caractéristiques de ces codes est d'incorporer des mots de contrôle et/ou de commande qui permettent notamment de récupérer des signaux d'horloge à l'extrémité réceptrice des séquences binaires émises, mais aussi commandent les modalités d'émission et de réception des dispositifs situés aux deux extrémités de la chaîne (émetteur et récepteur).

Cependant, si ce type de codes permet de résoudre, au moins partiellement, les problèmes évoqués ci-dessus, cette technique n'est pas sans inconvénients.

Ces codes impliquent notamment la mise en oeuvre de circuits très complexes. En pratique, ils sont essentiellement utilisés pour des liaisons "longue distance".

Or, un des besoins qui se fait sentir dans les technologies récentes de l'information est lié à la multiplication, au sein d'un même dispositif, voire sur une même carte de circuits électroniques, de liaisons séries asynchrones. A titre d'exemple, dans un même dispositif, il s'agit de liaisons cartes à cartes. Sur une même carte, il s'agit de liaisons entre modules ou circuits intégrés ("chips"). Pour fixer les idées, le nombre de liaisons peut atteindre plusieurs dizaines d'unités, par exemple typiquement 72 liaisons séries asynchrones entre deux "chips".

Dans ce cadre d'application préférée de l'invention, les transmissions considérées ont pour caractéristique essentielle de s'effectuer sur de courtes distances, quelques centimètres, voire quelques millimètres. D'autre part, les technologies actuelles permettent la mise en oeuvre de fréquences très élevées, couramment supérieures à 2,5 Mbits/s.

On comprend que, dans ces conditions, les solutions de l'art connu, notamment la mise en oeuvre de codes dits "DC balanced" impliquant une grande complexité en terme de circuits électroniques, ne puissent être satisfaisantes, ce d'autant plus que la proximité des circuits et/ou modules n'imposent pas l'incorporation de mots de commande dans les séquences binaires transmises.

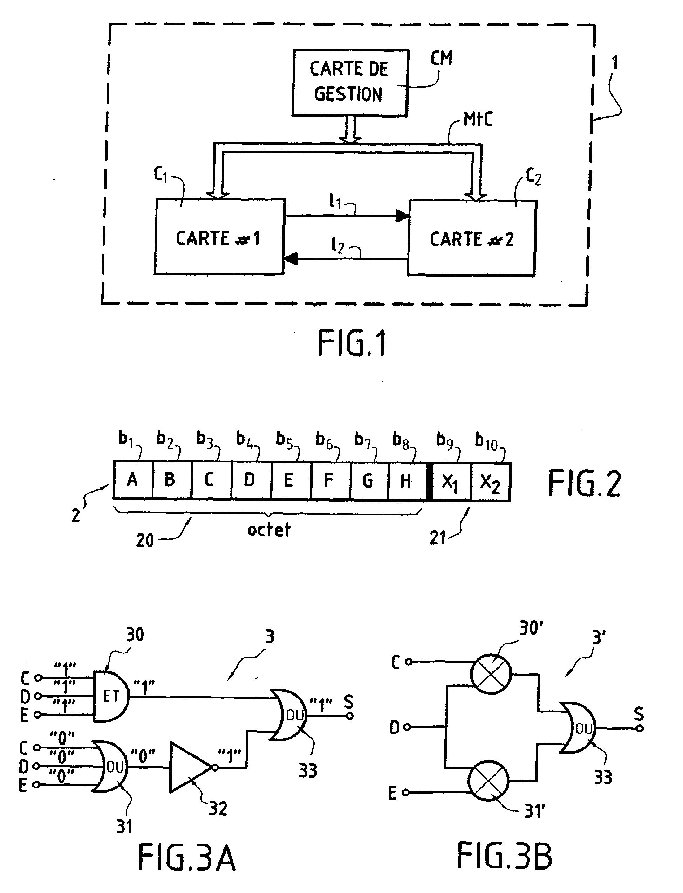

La figure 1, placée en annexe de la présente description, illustre schématiquement un exemple d'architecture de liaisons séries asynchrones, I₁ et I₂, entre deux cartes de circuits électroniques, C₁ et C₂ respectivement, placées à proximité l'une de l'autre dans une même unité 1. Une troisième carte de circuits électroniques, que l'on appellera "carte de gestion" CM transmet des mots de commande MtC, par exemple via un bus unique, aux deux cartes électroniques, C₁ et C₂, qui sont en relation de proximité.

S'il n'est pas obligatoire, pour des liaisons à courte distance, d'incorporer des mots de commande dans les séquences binaires transmises, il est par contre nécessaire, quel que soit le procédé de codage mis en oeuvre, de satisfaire toutes les autres exigences rappelées.

Il est en outre important que le procédé de codage ne multiplie pas les erreurs si un ou plusieurs bits se mettent en erreur (inversion de leurs états logiques). Cette exigence est notamment importante si on met en oeuvre des dispositions de détection et de correction d'erreurs (codes dits "ERC" ou "Error Recovery Code"). En réception, le message décodé et traité par les circuits "ERC" doit être identique au message d'origine émis, même si des erreurs se sont produites en cours de transmission.

L'invention vise à pallier les inconvénients des dispositifs et systèmes de l'art connu, et dont certains viennent d'être rappelés, tout en satisfaisant aux besoins qui se font sentir.

En particulier, le procédé selon l'invention permet de simplifier grandement les circuits de codage nécessaires à sa mise en oeuvre, ce sans dégradation de la qualité des transmissions.

De façon plus particulière, mais non exclusivement, les applications préférées de l'invention concernent un codage du type dit "8B/10B". Comme il a été indiqué la lettre "B" signifie "bits". Ce type de code est particulièrement intéressant, car il permet de traiter le cas d'octets comportant précisément 8 bits, que l'on qualifiera "d'utiles", car véhiculant de l'information. On complète l'octet par 2 bits surnuméraires, dans des états logiques "1" ou "0" particuliers. De tels codes sont connus en soi. Un exemple peut être trouvé dans le brevet américain US 5 025 256 A (International Computers Limited).

Les documents WO 98/34413, EP 0 751 522 et US 5 748 119 décrivent des procédés et dispositifs de codage/décodage de données numériques à base de codes en blocs.

L'invention a donc pour objet principal un procédé de codage/décodage de données numériques destinées à être transmises sur une liaison série, lesdites données numériques comprenant une première séquence de bits dite de données et une deuxième séquence de bits dite de "label", caractérisé en ce que, lesdites premières et deuxièmes séquences ayant des première et deuxième longueurs de bits déterminées, il comporte au moins une phase de codage comprenant au moins une étape de contrôle d'au moins une tranche d'au moins deux bits consécutifs, chacune desdites tranches étant située dans une zone prédéterminée de ladite première séquence de bits, de manière à réaliser un découpage de celle-ci en parties de longueurs sensiblement égales, ledit contrôle consistant à effectuer un test pour déterminer si les bits consécutifs de chacune desdites tranches sont dans un même état logique, "0" ou "1", une deuxième étape consistant à positionner les bits de ladite deuxième séquence à des configurations d'états logiques prédéterminés en relation biunivoque avec le résultat dudit test, et une étape d'inversion d'au moins un bit desdites tranches lorsque le résultat dudit test est positif et de transmission de ladite première séquence de bits sans modifications lorsque le résultat dudit test est négatif.

L'invention a encore pour objet un dispositif pour la mise en oeuvre de ce procédé.

L'invention va maintenant être décrite de façon plus détaillée en se référant aux dessins annexés, parmi lesquels :
- la figure 1 illustre schématiquement une architecture de liaisons séries asynchrones entre deux cartes de circuits électroniques ;
- La figure 2 illustre un mot binaire codé selon le procédé "8B"/10B" ;
- les figures 3A et 3B illustrent des exemples de circuits de détection de configuration particulière du mot de la figure 2 utilisable dans un codeur pour la mise en oeuvre du procédé de l'invention ;
- la figure 4 illustre un exemple de réalisation d'un codeur complet selon l'invention incorporant l'un ou l'autre des circuits des figures 3A ou 3B ;
- la figure 5 illustre un exemple de circuit de détection utilisable dans un décodeur pour la mise en oeuvre du procédé de l'invention pour un mot codé par le circuit de la figure 4 ;
- les figures 6 et 7 illustrent des exemples de circuits détecteurs d'erreurs dans les mots codés reçus par le décodeur ; et
- les figures 8A et 8B illustrent des mots codés selon l'invention de longueurs quelconques.

On va maintenant décrire de façon plus détaillée un exemple de réalisation préférée du procédé de codage de données numériques transmises sur une liaison série asynchrone selon l'invention. Pour fixer les idées, dans un premier temps et sans que cela soit limitatif à quel que titre que ce soit de sa portée, on se placera dans le cadre des applications préférées de l'invention, à savoir un codage de type "8B/10B".

La figure 2 illustre un mot binaire 2 de dix bits, notés b₁ à b₁₀. Les positions de bits 20, b₁ à b₈, que l'on a référencé "A" à "H", constituent les bits de données proprement dites ou données utiles (octet). Les positions "A" à "H" peuvent prendre, chacune, les états logiques "1" ou "0".

Les deux bits surnuméraires 21, b₉ et b₁₀, sont référencés "X₁" et "X₂" sur la figure 2. On peut appeler ces bits "label" ou "pattern", selon la terminologie anglo-saxonne. Dans un mode de réalisation préféré, ces bits sont simplement concaténés aux huit autres bits de l'octet 2. L'état logique, "1" ou "0", des deux bits, b₉ et b₁₀, dépend des valeurs logiques d'au moins certains des autres bits, b₁ à b₈, du mot 2, et obéit à des règles qui vont être précisées.

Dans le cas général, les huit bits, b₁ à b₈, de l'octet 20 sont transmis tel quel et les bits de label 21 prennent alors les états logiques "01" (b₉b₁₀). Le label 21 peut être concaténé indifféremment devant ou derrière les bits de l'octet 20, le bit b₁ ("A") étant supposé être émis en premier des bits de l'octet 20.

Le mot binaire complet 2 prend donc la configuration logique "ABCDEFGH01".

Par contre, dans le cas où trois bits consécutifs de la zone centrale de l'octet 20 sont au même état logique ("0" ou "1" respectivement), on inverse le bit central de cette zone pour augmenter la densité de transition. On choisit soit le triplet de bits b₃b₄b₅ (positions "CDE"), soit le triplet de bits b₄b₅b₆ (positions "DEF"). Le bit central est donc le bit b₄ (position "D") dans le premier cas ou le bit b₅ (position "E") dans le second cas. Le choix des trois bits est effectué *a priori* une fois pour toute pour une réalisation donnée.

Dans ce cas, on impose au label 21 la configuration logique "10" (b₉b₁₀).

A titre d'exemple, si l'octet 20 a la valeur logique "11111000", le mot complet est codé comme suit : "11101000-10", étant entendu que le tiret est simplement utilisé pour mettre en évidence la séparation entre l'octet 20 et le label 21, mais qu'il n'a pas d'existence physique, les deux suites de bits étant émises l'une à la suite de l'autre sans, *a priori,* d'intervalle de temps les séparant. On constate que le bit b₄ (position "D") a été inversé par rapport à sa valeur logique originelle.

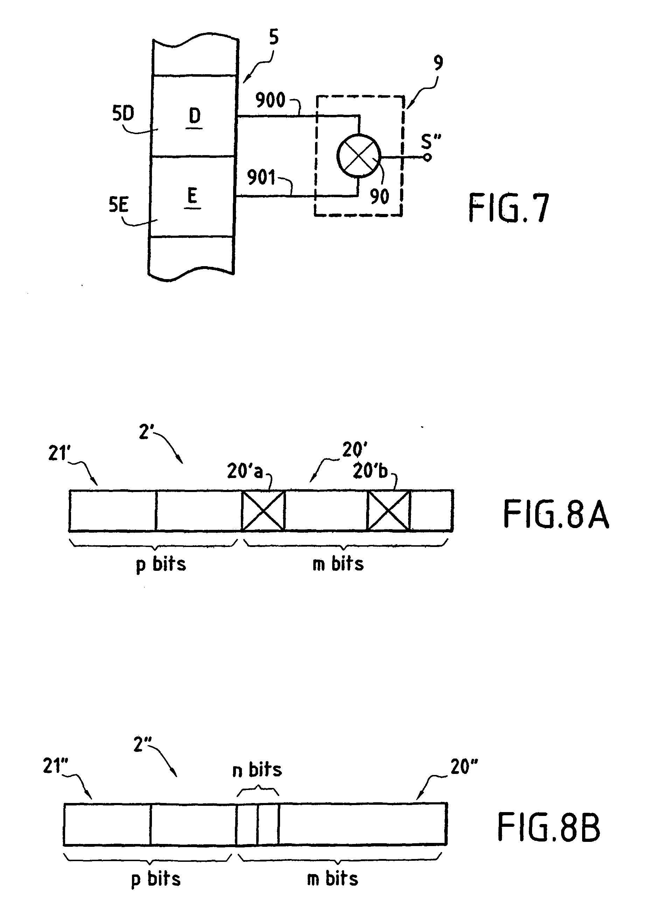

Par le procédé de codage selon l'invention, les caractéristiques suivantes sont obtenues :
- fréquence minimale de transition : 2 pour 10 bits, soit 20 % ;
- nombre maximum de bits identiques consécutifs ou "max run lenght" : 6, lorsque la détection de non-transition porte sur 3 bits consécutifs d'une zone centrale (voir figures 3A et 3B ci-après) et 5, lorsque cette même détection porte sur 2 bits seulement (voir figure 7 ci-après) ; et
- non-multiplication des erreurs et respect des codes "ERC" transmis.

En effet, en ce qui concerne cette dernière caractéristique, si les données (octet 20) sont entachées d'une ou plusieurs erreur(s), cette ou ces erreur(s) est(sont) simplement transmise(s). Par contre, dans le cas d'un transcodage selon l'art connu, il existe un risque réel de multiplication des erreurs.

En outre, le dispositif nécessaire pour obtenir le codage est très simple à réaliser.

La figure 3A illustre un premier exemple de réalisation à base d'une porte logiques "ET", 30, et de deux portes logiques "OU", 31 et 33, et d'un inverseur 32.

Sur la figure 3A, on a supposé que les trois positions de bit centrales "CDE" ont été retenues. Les portes logiques "ET" 30 et "OU" 31 ont trois entrées, recevant chacune l'un des trois signaux du triplet "CDE". La sortie de la porte logique "OU" 31 est reliée à l'entrée de l'inverseur 32. La sortie de l'inverseur 32 est relié à une première entrée de la porte logique "OU" 33. Une seconde entrée reçoit directement la sortie de la porte logique "ET" 30. Comme illustré sur la figure 3A, la porte logique "ET" 30 détecte l'apparition simultanée de bits à l'état "1" logique (sortie de cette porte à l'état "1" logique") et la porte logique "OU" 31 détecte l'apparition simultanée de bits à l'état "0" logique (sortie de cette porte à l'état "0" logique"). Dans ces deux cas, la porte logique "OU" 33 reçoit un "1" logique sur l'une ou l'autre de ses entrées. La sortie S de cette porte passe alors au "1" logique, ce qui indique que les trois bits centraux, b₃b₄b₅ (positions "CDE" dans l'exemple), sont dans un même état logique (soit "111", soit "000"). L'application des règles bien connues de la logique combinatoire montre que, dans tous les autres cas, la sortie S est au "0" logique, ce qui indique que ces trois bits centraux ne sont pas dans un même état logique et que l'octet 20 peut être transmis tel quel.

La figure 3B illustre un autre exemple de réalisation d'un circuit logique 3' remplissant la même fonction que le circuit 3 de la figure 3A, c'est-à- dire le test des bits du triplet dans un même état logique. Ce circuit est constitué de deux portes logiques "OU-EXCLUSIF" à deux entrées, 30' et 31', la première recevant sur ses entrées les bits des positions "C" et "D" (ou "D" et "E" si le triplet "DEF" avait été choisi), la seconde recevant sur ses entrées les bits des positons "D" et "E" " (ou "E" et "F" si le triplet "DEF" avait été choisi). Les sorties des portes "OU-EXCLUSIF", 30' et 31', sont transmises aux deux entrées d'une porte logique "OU" 33, jouant un rôle similaire à la porte de même référence de la figure 3A, dont la sortie est référencée S. Cependant, dans le cas du circuit de la figure 3A, la sortie S délivre un signal à l'état logique "0" pour une configuration dans laquelle tous les bits du triplet d'entrée sont dans un même état logique (soit "111", soit "000"). Si le signal en sortie de cet inverseur doit prendre l'état logique "1" pour cette même configuration logique, il y lieu de faire suivre la porte "OU" 33 d'un inverseur (non représenté).

Le signal en sortie S sert à commander l'inversion du bit b₄ (position "D"), ou b₅ (position "E") selon les cas.

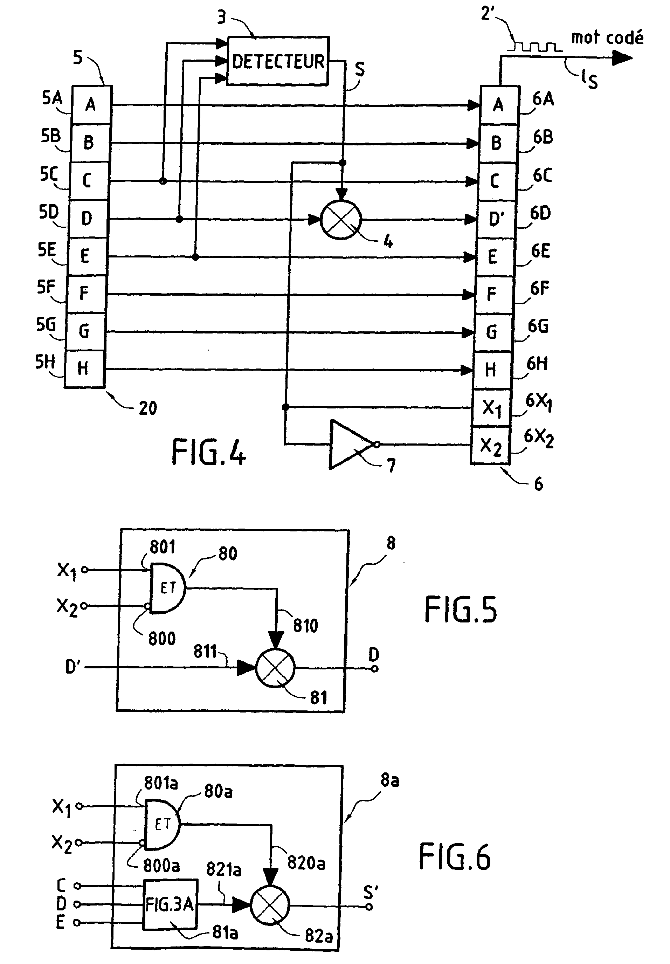

On va décrire maintenant un exemple de circuit complet de codage selon l'invention et ses circuits annexes par référence à la figure 4.

On suppose que l'octet 21 est tout d'abord stocké dans un registre 5 ou tout autre organe similaire (bascules de type "JK", positions de mémoire vive, etc.). Les positions "A" à "H" sont enregistrées dans huit cellules de ce registre 5, soit 5A à 5H. Les sorties des cellules centrales 5C à 5E (par exemple) sont transmises aux entrées des circuits 3 (figure 3A ou 3' : figure 3B), que l'on peut appeler détecteur. A l'exception de la sortie de la cellule 5D (position "D"), les sorties des autres cellules, 5A à 5C et 5E à 5H, sont également transmises aux entrées correspondantes des cellules, 6A à 6C et 6E à 6H d'un second registre 6. Il s'ensuit que les positions A à C et E à H sont les simples copies des positions correspondantes du registre 5. Par contre la sortie de la cellule 5D (position "D") est transmise à l'entrée de la cellule 6D via une porte logique de type "OU-EXCLUSIF" 4. Celle-ci reçoit dont sur une première entrée la sortie de la cellule 5D et sur une seconde entrée la sortie S des circuits détecteurs 3.

La position de mémoire de la cellule 6D du registre 6 est référencée D', car elle n'est plus une simple copie de la position D. Si la sortie S est à l'état logique "0", "D" et "D' " sont identiques (tous deux au "0" logique, par exemple). C'est le cas général. Par contre, si les circuits 3 détectent trois bits consécutifs au même état logique (voir figure 3A), la sortie S passe au "1" logique et le bit correspondant à "D" est inversé.

Dans l'exemple illustré sur la figure 4, le registre 6 comporte deux cellules supplémentaires, 6X₁ et 6X₂, destinées à stocker les bits de label (positions référencées X₁ et X₂). Ces bits peuvent être générés simplement à partir de la sortie S. il suffit de relier celle-ci directement à l'entrée de la première cellule supplémentaire 6X₁ et, par l'intermédiaire d'un inverseur 7, à l'entrée de la seconde cellule supplémentaire 6X₂.

Dans le cas général, S est à l'état logique "0". Il s'ensuit que X₁ est à l'état logique 0" et X₂ à l'état logique "1" grâce à l'inverseur 7. Lorsque S est à l'état logique "1", on obtient la situation duale de la précédente, soit "10".

Une fois codé, le mot binaire codé complet 2 (figure 2 : octet 20 et label 21) est émis et transmis par une liaison série lₛ à un organe récepteur (non représenté). Les circuits nécessaires à la bonne transmission du mot binaire 2 dépendent de l'application précise envisagée et sont bien connus en soi de l'Homme de Métier. Il est inutile de les décrire plus avant.

En réception, le processus inverse doit être réalisé. Si le label 21 a la configuration logique "01", cela signifie qu'il n'y a pas eu de codage à proprement parlé. L'octet 20 peut être accepté tel quel, sans inversion du bit central b₄ (position "D"). Par contre, si la configuration est "10", cela signifie que le bit central doit être inversé.

La figure 5 illustre schématiquement un exemple de réalisation d'un circuit logique 8 permettant, à la fois, la détection nécessaire et l'opération d'inversion sélective. Ce circuit 8 comprend une porte logique "ET" 80, dont une entrée 800 est inverseuse et l'autre, 801, directe, et qui reçoivent les bits de label, X₂ et X₁, respectivement. La sortie de cette porte logique "ET" 80 est transmise à une première entrée, 810, d'une porte logique "OU-EXCLUSIF" 81, recevant sur une seconde entrée, 811, le bit transmis correspondant à la position "D' ". En appliquant les règles de la logique combinatoire, on constate aisément que le bit en sortie (position "D") du circuit logique 8 n'est pas modifié si la configuration "X₁X₂" est "01" et inversé si configuration est "10".

Le mot disponible sur l'organe récepteur, en particulier la partie "utile" correspondant à l'octet d'information 20, est donc bien reconstitué correctement.

Dans une première variante supplémentaire du procédé selon l'invention, on peut également vérifier certaines erreurs associées au label 21. En effet, dans l'exemple décrit, il ne peut prendre que les configurations logiques "01" et 10". Les configurations "00" et 11" ne sont donc pas possibles et indiquent que ce label 21 est entaché d'erreur. Un circuit logique simple, similaire à celui de la figure 3A, par exemple, permet de détecter ces deux configurations. Au lieu d'utiliser des portes logiques "ET" à trois entrées (figure 3A : 30 et 31), on utilise des portes logiques à deux entrées. Cellules-ci reçoivent les bits des positions "X₁" et "X₂". A cette exception près, la configuration du circuit de détection d'erreur sur le label 21 peut être identique à celle du circuit de la figure 3A. La sortie de la porte logique "OU" (figure 3A : 33) à l'état logique "1" indique une erreur. En effet, pour obtenir ce résultat, il est nécessaire que les bits des positions "X₁" et "X₂" soient dans un même état logique, "1" ou "0".

On peut constater également qu'une erreur double sur le label 21 se traduit par une erreur simple sur la partie données (octet 20), dont par une réduction d'erreur et non une multiplication.

Dans une deuxième variante de réalisation, on effectue avantageusement un contrôle supplémentaire sur les bits de données (octet 20). En effet, si la configuration de label ("10") a provoqué l'inversion du bit central en réception (par exemple de la position "D"), on doit retrouver trois bits centraux (positions "CDE") dans un même état logique "000" ou "111". L'une ou l'autre de ces configurations peut être détectée très simplement.

Le circuit logique de la figure 6 illustre un exemple de circuit 8a permettant cette détection. Dans la pratique, le circuit 8a peut être constitué par l'association d'une porte logique "ET" 80a, avec une entrée directe 801a et une entrée inverseuse 800a, recevant les bits de positions "X₁" et "X₂", et un circuit logique 81a identique à celui de la figure 3A (ou 3B) par exemple. En effet, ce dernier doit délivrer sur sa sortie, comme dans le cas de la figure 3A (ou 3B), un signal à l'état logique "1" seulement, et seulement si, toutes ses entrées sont au même état logique "1" ou "0". La porte logique 80a détecte la configuration logique "10" des bits de positions "X₁X₂" et délivre, dans ce cas, un signal à l'état logique "1". On compare ces deux signaux de sortie à l'aide d'un "OU-EXCLUSIF" 82a qui les reçoit sur ses entrées, 820a et 821a, et qui délivre sur sa sortie S' un signal à l'état logique "0" seulement, et seulement si, ses deux entrées sont au même état logique "1" ou "0", et à l'état logique "1", dans les cas contraires, ce qui indique qu'il y a erreur. En effet, les deux entrées à l'état logique "1" indiquent que les bits des positions "CDE" sont tous au même état logique ("1" ou "0") et qu'il y a eu inversion (configuration de "X₁X₂" = "10"), et les deux entrées à l'état logique "0" indiquent que les bits des positions "CDE" sont dans des états logiques différents et qu'il n'y a pas eu inversion (configuration de "X₁X₂" = "01"). Ces deux cas indiquent, *a priori,* qu'il n'y a pas d'erreurs.

On remarque que la porte logique 80a peut être omise. En effet, il suffit de transmettre la sortie de la porte logique 80 (figure 5) aussi à l'entrée 820a de la porte logique "OU-EXCLUSIF" 82a, ce qui constitue une simplification supplémentaire.

Dans une autre variante de réalisation encore du procédé selon l'invention, on vérifie seulement qu'il n'y a pas de transition entre deux bits centraux successifs, par exemple les bits b₄ et b₅ (positions "D" et "E") si on se reporte de nouveau à la figure 2. Ces deux positions sont à fixer à l'avance.

La figure 7 illustre un exemple de réalisation d'un circuit logique 9 permettant d'obtenir une telle détection. Ce circuit est réalisé à l'aide d'une simple porte logique "OU-EXCLUSIF" 90, à deux entrées, 900 et 901. Dans l'exemple décrit, les bits des positions "D" et "E" sont transmis à ces entrées. L'état de la sortie S" du circuit 9 permet de détecter l'absence ou la présence de transitions entre les bits des positions "D" et "E".

Jusqu'à ce point de la description, on a supposé que le segment "utile" du mot, c'est-à-dire les données d'information, occupaient un octet et que l'on se plaçait dans le cadre des applications préférées de l'invention, à savoir le codage dit "8B/10B".

Cependant, comme il a été indiqué, le procédé selon l'invention ne se limite pas à cette seule application. Le mot codé et la partie données d'information peuvent naturellement se présenter sur des longueurs différentes , notamment plus importantes.

La figure 8A illustre, de façon générale, un mot à coder 2' de structure conforme à l'invention. Les données d'information 20' occupent une séquence de longueur arbitraire m bits et le label 21' une séquence de longueur p bits. Pour assurer notamment un "Maximum Run-Length" ("MRL"), ou nombre de bits successifs maximum prédéterminé qui sont susceptibles de rester à une même valeur, "0" ou "1" logique, il est nécessaire de surveiller la configuration d'une ou plusieurs tranche(s) de n bits consécutifs dans des zones prédéterminées de la séquence 20'.

Sur la figure 8A on a représenté deux tranches de bits, 20'a et 20'b. la longueur de chacune des tranches est au minimum de deux bits consécutifs. Le paramètre "MLR" dépend du nombre de bits surveillé et de la répartition des tranches. Il est avantageux de les rendre équi-réparties sur la séquence de m bits (données d'information 20'), ou pour le moins sensiblement équi-réparties.

De cette façon, les tranches découpent la séquence de m bits (données d'information 20') de façon sensiblement régulière. Les tranches, 20'a et 20'b, sont donc situées (au moins approximativement) au tiers et deux tiers de la séquence de m bits, celle-ci étant découpée en trois parties sensiblement de mêmes longueurs.

De façon similaire, s'il existe trois tranches (exemple non représenté), celles-ci seront situées approximativement au quart, à la moitié et au trois quarts de la séquence de m bits, celle-ci étant découpée en quatre parties sensiblement de mêmes longueurs.

Enfin, si t est le nombre de tranches surveillées, le nombre de bits surnuméraire (label 21') est rendu égal à p, avec p ≥ t.

En choisissant p = t+1, on peut garantir au moins une transition dans le label 21'. Cette configuration constitue un cas particulier qui vient d'être décrit de façon détaillée pour un codage du type "8B/10B". Cette transition systématique peut servir de point de repère pour l'équi-répartition du découpage des tranches.

En choisissant p=t+2, on peut garantir au moins deux transitions dans le label 21'.

Le nombre de transitions augmente corrélativement à la valeur de p. Une telle solution s'applique avantageusement lorsque le nombre de tranches et donc la valeur de p sont élevés.

La figure 8B illustre le cas le plus général. Le mot 2" comprend comme précédemment une séquence de données 20" de m bits et un label 21" de p bits. Les circuits de surveillance et de détection (par exemple figure 3A ou figure 7) contrôlent la configuration d'au moins une tranche 20"a d'au moins 2 bits consécutifs, de façon générale une tranche de n bits.

De façon similaire à ce qui a été précédemment décrit, on inverse au moins un bit déterminé de tranche lorsque tous les bits sont détectés dans un même état logique, "0" ou "1". Les configurations de tranches sont forcées à des configurations logiques prédéterminées en fonction de cette détection. Le décodage s'effectue aussi de la manière décrite pour le cas "8B/10B" sur l'examen de la configuration du label. Il s'ensuit également que l'on peut effectuer aussi des tests supplémentaires en détectant des configurations logiques non permises du label. Ce dernier, en fonction de sa longueur en bit peut prendre un ensemble de configurations logiques possibles. Les combinaisons autorisées forment un premier sous-ensemble, les combinaisons non autorisées un second sous-ensemble, dual du premier. On peut enfin tester, au décodage, lorsqu'il y a eu inversion de bit si tous les bits de tranches sont au même état logique.

A la lecture de ce qui précède, on constate aisément que l'invention atteint bien les buts qu'elle s'est fixés.

Le procédé selon l'invention permet notamment de garantir :
- un taux de transitions préétablies parmi tous les bits constituant une séquence binaire ;
- un "Maximum Run-Length" ("MRL") ou nombre de bits successifs maximum susceptibles de rester à une même valeur, "0" ou "1" logique ; et
- une non-multiplication d'erreurs des données transmises.

En outre, selon une caractéristique très avantageuse, ces propriétés sont obtenues en ne mettant en oeuvre que des circuits logiques très simples, ce qui permet d'accommoder de nombreuses liaisons séries dans un même dispositif, voir sur une même carte de circuits intégrés ("chips") sans en augmenter le prix de revient, ni la complexité de façon importante.

Il doit être clair cependant que l'invention n'est pas limitée aux seuls exemples de réalisations explicitement décrits, notamment en relation avec les figures 3A à 8.

Elle n'est pas non plus limitée, comme il a été indiqué, seulement au codage de type "8B/10B".

## Revendications

1. Procédé de codage/décodage de données numériques destinées à être transmises sur une liaison série, lesdites données numériques comprenant une première séquence de bits dite de données et une deuxième séquence de bits dite de "label", **caractérisé en ce que**, lesdites première (20, 20') et deuxième (21, 21') séquences ayant des première (m) et deuxième ((p) longueurs de bits déterminées, il comporte au moins une phase de codage comprenant au moins une étape de contrôle (3, 3', 9) d'au moins une tranche (CDE, 20'a-20'b) d'au moins deux bits consécutifs, chacune desdites tranches étant située dans une zone prédéterminée de ladite première séquence de bits (20, 20'), de manière à réaliser un découpage de celle-ci en parties de longueurs sensiblement égales, ledit contrôle (3, 3', 9) consistant à effectuer un test pour déterminer si les bits consécutifs de chacune desdites tranches (CDE, 20'a-20'b) sont dans un même état logique, "0" ou "1 ", une deuxième étape (7) consistant à positionner les bits (X₁, X₂) de ladite deuxième séquence (21, 21') à des configurations d'états logiques prédéterminés en relation biunivoque avec le résultat dudit test, et une étape d'inversion (4) d'au moins un bit desdites tranches ("CDE, 20'a-20'b) lorsque le résultat dudit test est positif et de transmission de ladite première séquence de bits (20, 20') sans modifications lorsque le résultat dudit test est négatif.

2. Procédé selon la revendication 1, **caractérisé en ce que** le nombre de bits (p) de ladite deuxième séquence est plus grand ou égal au nombre desdites tranches (t).

3. Procédé selon la revendication 1 ou 2, **caractérisé en ce que**, ledit codage étant du type dit "8B/10B", ladite première séquence (20) ayant une longueur de 8 bits, de manière à former un octet de données dont les positions successives (A ... H) sont numérotées 1 à 8, et ladite deuxième séquence (21) une longueur de 2 bits, il comprend le contrôle d'une tranche de 3 bits (CDE) incluant le bit numéro 5, et **en ce que** lesdits bits (X₁, X₂) de ladite deuxième séquence (21) sont positionnés suivant la configuration logique "10" lorsque le résultat dudit contrôle indique que lesdits trois bits (CDE) de ladite tranche sont au même état logique "0" ou "1" et suivant la configuration logique "01" dans le cas contraire.

4. Procédé selon la revendication 1 à 3, **caractérisé en ce qu'**il comporte une phase de décodage desdites données numériques codées comprenant au moins une étape de contrôle (8) de la configuration de l'état logique des bits (X₁, X₂) de ladite deuxième séquence et une étape d'inversion sélective d'au moins un bit (D') desdites tranches sur détection, lors dudit contrôle, de configurations logiques prédéterminées de ladite deuxième séquence, de manière à rétablir ladite première séquence dans son état originel.

5. Procédé selon la revendication 4, **caractérisé en ce que** lesdites configurations logiques pouvant être prises par les bits (X₁, X₂) de ladite deuxième séquence étant comprises dans un premier sous-ensemble de toutes les combinaisons possibles permises par le nombre de bits constituant cette séquence, il comprend une étape de détection de configurations d'états logiques non permis, constitué par un deuxième sous-ensemble dual du premier, indiquant au moins une erreur survenue sur ladite deuxième séquence.

6. Procédé selon la revendication 4, **caractérisé en ce que** lorsque ladite étape de contrôle de la configuration de l'état logique des bits (X₁, X₂) de ladite deuxième séquence montre la présence d'une inversion de bit lors du codage, dans au moins une desdites tranches (CDE), il comprend une étape supplémentaire (8a) consistant, après décodage, à vérifier que tous les bits de ladite tranche sont dans un même état logique, "1" ou "0".

7. Dispositif de codage/décodage de données numériques destinées à être transmises sur une liaison série, lesdites données numériques comprenant une première séquence de bits dite de données et une deuxième séquence de bits dite de "label", **caractérisé en ce que**, lesdites première (20, 20') et deuxième (21, 21') séquences ayant des première (m) et deuxième (p) longueurs de bits déterminées, il comprend un codeur comprenant au moins un premier organe (3, 3', 9) pour le contrôle d'au moins une tranche d'au moins deux bits consécutifs (CDE), chacune desdites tranches étant située dans une zone prédéterminée de ladite première séquence de bits (20, 20'), de manière à réaliser un découpage de celle-ci en parties de longueurs sensiblement égales, ledit premier organe (3, 3', 9) effectuant un test pour déterminer si les bits consécutifs de chacune desdites tranches sont dans un même état logique, "0" ou "1 ", et délivrant sur sa sortie (S, S") un signal à un premier état logique déterminé lorsque ledit test est positif et à un second état logique déterminé lorsque ledit test est négatif, un deuxième organe (4) recevant le signal de sortie (S, S") dudit premier organe (3, 3', 9) sur une première entrée et un bit déterminé (D) desdites tranches (CDE) sur une seconde entrée, de manière à le transmettre inchangé lorsque ledit test est négatif et à l'inverser lorsque ledit test est positif, et un troisième organe (7) commandé par ledit signal de sortie pour positionner les bits de la deuxième séquence à des configurations logiques prédéterminées, en relation biunivoque.

8. Dispositif selon la revendication 7, **caractérisé en ce que**, ledit codage étant du type dit "8B/10B", ladite première séquence (20) ayant une longueur de 8 bits, de manière à former un octet de données (A ... H) dont les positions successives sont numérotées 1 à 8, ladite deuxième séquence (21) une longueur de deux bits (X₁, X₂) et ladite tranche (CDE) une longueur de trois bits, ledit premier organe (3) comprend une porte logique "ET" (30) et une porte logique "OU" (31) en parallèle, chacune à trois entrées, de manière à recevoir sur chacune de leurs entrées un des trois bits de ladite tranche (CDE), incluant le bit numéro 5, et une porte logique "OU" (33) à deux entrées, recevant directement le signal de sortie de ladite porte logique "ET" (30) et, via un inverseur (32), le signal de sortie de ladite porte logique "OU" (31), de manière à délivrer en sortie (S) un signal à l'état logique "1" si, et seulement si, tous les bits de ladite tranche (CDE) sont dans un même état logique, "0" ou "1", **en ce que** ledit deuxième organe est une porte logique "OU-EXCLUSIF" (4) à deux entrées, recevant, sur une première entrée, le signal de sortie (S) dudit premier organe (3) et, sur une seconde entrée, le bit central (D) de ladite tranche de 3 bits (CDE), de manière à le transmettre inchangé lorsque ledit test est négatif et à l'inverser lorsque ledit test est positif, et **en ce que** ledit troisième organe comprend un inverseur (7) recevant en entrée ledit signal de sortie (S) dudit premier organe (3), ladite deuxième séquence étant constituée d'un premier bit (X₁) au même état logique que ce signal (S) et un second bit (X₂) au même état logique que le signal de sortie dudit inverseur (7).

9. Dispositif selon la revendication 7, **caractérisé en ce qu'**il comprend un décodeur comprenant au moins un organe de contrôle (8) de la configuration des bits (X₁, X₂) de ladite deuxième séquence de manière à inverser sélectivement au moins un bit (D') desdites tranches sur détection de configurations déterminées indiquant que ce bit a été inversé lors du codage et à rétablir ladite première séquence dans son état originel.

10. Dispositif selon la revendication 9, **caractérisé en ce que** ledit codage étant du type dit "8B/10B", ladite première séquence (20) ayant une longueur de 8 bits, de manière à former un octet de données dont les positions successives sont numérotées 1 à 8, ladite deuxième séquence (21) une longueur de deux bits, et ladite tranche (CDE) une longueur de trois bits, ledit organe de contrôle (8) comprend une porte logique "ET" (80) ayant une entrée directe (801) et une entrée inverseuse (800), les bits (X₁, X₂) de ladite deuxième séquence étant transmis à ces entrées respectives, et une porte logique "OU-EXCLUSIF" (81) à deux entrées, recevant, sur une première entrée (810), le signal de sortie de ladite porte logique "ET" (80) et, sur une seconde entrée (811), le bit central (D') de ladite tranche de trois bits, de manière à le transmettre inchangé lorsque la configuration logique de ladite seconde séquence est "01" et à l'inverser lorsque la configuration logique de ladite seconde séquence est "10".

11. Dispositif selon la revendication 9 ou 10, **caractérisé en ce qu'**il comprend un premier organe supplémentaire pour la détection d'erreur de la configuration des bits (X₁, X₂) de ladite deuxième séquence (21) par la détection d'une configuration logique prédéterminée.

12. Dispositif selon la revendication 9 ou 10, **caractérisé en ce qu'**il comprend un deuxième organe supplémentaire (8a) pour détecter une configuration erronée de ladite tranche (CDE) après décodage, lorsque la configuration logique des bits (X₁, X₂) de ladite deuxième séquence indique que ledit bit a été inversé lors dudit codage, ladite configuration erronée apparaissant lorsque les trois bits de ladite tranche sont au même état logique.

## Claims

1. Method for encoding/decoding digital data to be transmitted through a serial link, said digital data comprising a first so-called data bit sequence and a second so-called "label" bit sequence, **characterized in that**, said first (20, 20') and second (21, 21') sequences having first (m) and second (p) given bit lengths, it includes at least one encoding phase comprising at least a step for checking (3, 3', 9) at least one slice (CDE, 20'a-20'b) of at least two consecutive bits, each of said slices being located in a predetermined area of said first bit sequence (20, 20'), so as to create a partitioning of the latter into parts of approximately equal length, said check (3, 3', 9) consisting of performing a test to determine whether the consecutive bits of each of said slices (CDE, 20'a-20'b) are in the same logic state, "0" or "1," a second step (7) consisting of setting the bits (X₁, X₂) of said second sequence (21, 21') to predetermined logic state configurations in one-to-one relation with the result of said test, and a step for inverting (4) at least one bit of said slices (CDE, 20'a-20'b) when the result of said test is positive and for transmitting said first bit sequence (20, 20') without modifications when the result of said test is negative.

2. Method according to claim 1, **characterized in that** the number of bits (p) in said second sequence is greater than or equal to the number of bits in said slices (n).

3. Method according to claim 1 or 2, **characterized in that**, said coding being the so-called "8B/10B" type, said first sequence (20) having a length of 8 bits so as to form a data byte wherein the successive positions (A......H) are numbered 1 to 8, and said second sequence (21) having a length of 2 bits, it comprises the checking of a 3-bit slice (CDE) including the bit number 5, and **in that** said bits (X₁, X₂) of said second sequence (21) being set to the logic configuration "10" when the result of said check indicates that said three bits (CDE) of said slice are in the same logic state "0" or "1" and to the logic configuration "0" in the contrary case.

4. Method according to claim 1 to 3, **characterized in that** it includes a phase for decoding said encoded digital data comprising at least one step for checking (8) the logic state configuration of the bits (X₁, X₂) of said second sequence and a step for selectively inverting at least one bit (D') of said slices upon detection, during said check, of predetermined logic configurations of said second sequence, in order to re-establish said first sequence in its original state.

5. Method according to claim 4, **characterized in that**, said logic configurations that can be assumed by the bits (X₁, X₂) of said second sequence being included in a first subset of all the possible combinations permitted by the number of bits constituting this sequence, it includes a step for detecting non-permitted logic state configurations, constituted by a second subset, the counterpart of the first, indicating at least one error occurring in said second sequence.

6. Method according to claim 4, **characterized in that** when said step for checking the logic state configuration of the bits (X₁, X₂) of said second sequence indicates the presence of a bit inversion during the encoding, in at least one of said slices (CDE), it includes an additional step (8a) consisting, after decoding, of verifying that all the bits of said slice are in the same logic state, "1" or "0."

7. Device for encoding/decoding digital data to be transmitted through a serial link, said digital data comprising a first so-called data bit sequence and a second so-called "label" bit sequence, **characterized in that**, said first (20, 20') and second (21, 21') sequences having first (m) and second (p) given bit lengths, it comprises an encoder including at least one element (3, 3', 9) for checking at least one slice of at least two consecutive bits (CDE), each of said slices being located in a predetermined area of said first bit sequence (20, 20'), so as to create a partitioning of the latter into parts of approximately equal length, said first element (3, 3', 9) performing a test to determine whether the consecutive bits of each of said slices are in the same logic state, "0" or "I ", and delivering through its output (S, S") a signal in a first given logic state when said test is positive and in a second given logic state when said test is negative, a second element (4) receiving the output signal (S, S") from said first element (3, 3', 9) through a first input and a given bit (D) of said slices (CDE) through a second input, so as to transmit it unchanged when said test is negative and to invert it when said test is positive, and a third element (7) driven by said output signal for setting the bits of the second sequence to predetermined logic configurations, in one-to-one relation.

8. Device according to claim 7, **characterized in that**, said encoding being the "8B/10B" type, said first sequence (20) having a length of 8 bits so as to form a data byte (A .... H) wherein the successive positions are numbered 1 to 8, said second sequence (21) having a length of two bits (X₁, X₂), and said slice (CDE) having a length of three bits, said first element (3) comprises an "AND" logic gate (30) and an "OR" logic gate (31) in parallel, each with three inputs, in order to receive through each of their inputs one of the three bits of said slice (CDE) including the bit number 5, and an "OR" logic gate (33) with two inputs, receiving the output signal directly from said "AND" logic gate (30) and, via an inverter (32), the output signal from said "OR" logic gate (31), in order to deliver as output (S) a signal in the logic state "1" if, and only if, all the bits of said slice (CDE) are in the same logic state, "0" or "1 ,"in that said second element is an "EXCLUSIVE-OR" logic gate (4) with two inputs, receiving through a first input the output signal (S) from said first element (3), and through a second input the middle bit (D) of said 3-bit slice (CDE), so as to transmit it unchanged when said test is negative and to invert it when said test is positive, and **in that** said third element comprises an inverter (7) receiving as input said output signal (S) from said first element (3), said second sequence being constituted by a first bit (X₁) in the same logic state as this signal (S) and a second bit (X₂) in the same logic state as the output signal from said inverter (7).

9. Device according to claim 7, **characterized in that** it includes a decoder comprising at least one element for checking (8) the configuration of the bits (X₁, X₂) of said second sequence in order to selectively invert at least one bit (D') of said slices upon detection of given configurations indicating that this bit has been inverted during the encoding and to re-establish said first sequence in its original state.

10. Device according to claim 9, **characterized in that**, said encoding being the so-called "8B/10B" type, said first sequence (20) having a length of 8 bits so as to form a data byte wherein the successive positions are numbered I to 8, said second sequence (21) having a length of two bits, and said slice (CDE) having a length of three bits, said checking element (8) comprises an "AND" logic gate (80) having a direct input (801) and an inverting input (800), the bits (X₁, X₂) of said second sequence being transmitted to these respective inputs, and an "EXCLUSIVE-OR" logic gate (81) with two inputs, receiving through a first input (810) the output signal from said "AND" logic gate (80), and through a second input (811) the middle bit (D') of said three-bit slice, in order to transmit it unchanged when the logic configuration of said second sequence is "01" and to invert it when the logic configuration of said second sequence is "10".

11. Device according to claim 9 or 10, **characterized in that** it includes a first additional element for detecting errors in the configuration of the bits (X₁, X₂) of said second sequence (21) by detecting a predetermined logic configuration.

12. Device according to claim 9 or 10, **characterized in that** it includes a second additional element (8a) for detecting an erroneous configuration of said slice (CDE) after decoding, when the logic configuration of the bits (X₁, X₂) of said second sequence indicates that said bit has been inverted during said encoding, said erroneous configuration appearing when the three bits of said slice are in the same logic state.

## Patentansprüche

1. Verfahren zur Codierung/Decodierung digitaler Daten, die für die Übertragung über eine serielle Verbindung bestimmt sind, wobei die digitalen Daten eine erste Bitfolge umfassen, genannt Datenfolge, und eine zweite Bitfolge, genannt "Label"-Folge, **dadurch gekennzeichnet, dass**, wobei die erste (20, 20') und zweite (21, 21') Folge erste (m) und zweite (p) festgesetzte Bitlängen aufweisen, das Verfahren wenigstens eine Codierungsphase umfasst, die wenigstens einen Schritt (3, 3', 9) beinhaltet zur Prüfung wenigstens eines Abschnittes (CDE, 20'a bis 20'b) mit wenigstens zwei aufeinanderfolgenden Bits, wobei jeder der Abschnitte sich in einem vorbestimmten Bereich der ersten Bitfolge (20, 20') befindet, so dass eine Aufteilung der Folge in Teile mit im Wesentlichen gleicher Länge erfolgt, wobei die Prüfung (3, 3', 9) darin besteht, einen Test durchzuführen, um festzustellen, ob sich die aufeinanderfolgenden Bits in jedem dieser Abschnitte (CDE, 20'a - 20'b) in einem gleichen logischen Zustand, "0" oder "1", befinden, und einen zweiten Schritt (7), der darin besteht, die Bits (X₁, X₂) der zweiten Folge (21, 21') in eineindeutiger Relation zu dem Ergebnis des genannten Tests in vorbestimmte logische Zustandskonfigurationen zu setzen, und einen Schritt (4), in dem wenigstens ein Bit der Abschnitte ("CDE, 20'a - 20'b) invertiert wird, wenn das Ergebnis des Tests positiv ist, und einen Schritt, in dem die erste Bitfolge (20, 20') ohne Veränderung übertragen wird, wenn das Ergebnis des Tests negativ ist.

2. Verfahren gemäß Anspruch 1, **dadurch gekennzeichnet, dass** die Anzahl der Bits (p) der zweiten Folge größer oder gleich ist der Anzahl der Abschnitte (t).

3. Verfahren gemäß Anspruch 1 oder 2, **dadurch gekennzeichnet, dass** mit einer Codierung des sogenannten "8B/10B"-Typs, einer Länge der ersten Folge (20) von 8 Bits, so dass ein Datenbyte (A...H) geformt wird, dessen aufeinanderfolgenden Positionen (A ... H) von 1 bis 8 durchnummeriert sind, einer Länge der zweiten Folge (21) von 2 Bits, es die Prüfung eines Abschnitts von 3 Bits (CDE) umfasst, der das Bit Nr. 5 enthält, und ferner **dadurch gekennzeichnet ist, dass** die Bits (X₁, X₂) der zweiten Folge (21) gemäß der logischen Konfiguration "10" gesetzt werden, wenn das Ergebnis der Prüfung anzeigt, dass die drei Bits (CDE) des Abschnitts im gleichen logischen Zustand, "0" oder "1" sind, und im gegenteiligen Fall in der logischen Konfiguration "01" gesetzt werden.

4. Verfahren nach einem der Ansprüche 1 bis 3, **dadurch gekennzeichnet, dass** es eine Decodierphase der codierten digitalen Daten umfasst, mit wenigstens einem Schritt (8) zum Prüfen der Konfiguration des logischen Zustands der Bits (X₁, X₂) der zweiten Folge und einem Schritt, in dem selektiv wenigstens ein Bit (D') der Abschnitte invertiert wird, wenn bei der Prüfung vorbestimmte logische Konfigurationen der zweiten Folge erkannt werden, so dass die erste Folge in ihren Ursprungszustand zurückversetzt wird.

5. Verfahren gemäß Anspruch 4, **dadurch gekennzeichnet, dass**, wobei die logischen Konfigurationen, die von den Bits (X₁, X₂) der zweiten Folge eingenommen werden können, in einer ersten Untergruppe von allen, durch die Anzahl der die Folge bildenden Bits erlaubten, möglichen Kombinationen enthalten sind, das Verfahren einen Schritt umfasst, in dem logische Zustandskonfigurationen erkannt werden, die nicht erlaubt sind, gebildet durch eine zur ersten duale zweite Untergruppe, wodurch wenigstens ein auf der zweiten Folge aufgetretener Fehler angezeigt wird.

6. Verfahren gemäß Anspruch 4, **dadurch gekennzeichnet, dass** es einen zusätzlichen Schritt (8a) umfasst, wenn während des Schritts zum Prüfen der logischen Zustandskonfiguration der Bits (X₁, X₂) der zweiten Folge die Anwesenheit einer Bitinversion in wenigstens einem der Abschnitte (CDE) während der Codierung angezeigt wird, wobei der Schritt darin besteht, nach der Decodierung zu nachzuprüfen, dass alle Bits des Abschnitts in einem gleichen logischen Zustand, "1" oder "0", sind.

7. Vorrichtung zur Codierung/Decodierung digitaler Daten, die für die Übertragung über eine serielle Verbindung bestimmt sind, wobei die digitalen Daten eine erste Bitfolge umfassen, genannt Datenfolge, und eine zweite Bitfolge, genannt "Label"-Folge, **dadurch gekennzeichnet, dass** die Vorrichtung, wobei die erste (20, 20') und zweite (21, 21') Folge erste (m) und zweite (p) festgesetzte Bitlängen aufweisen, einen Codierer umfasst, der wenigstens ein erstes Mittel (3, 3', 9) aufweist zum Prüfen wenigstens eines Abschnittes mit wenigstens zwei aufeinanderfolgenden Bits (CDE), wobei jeder der Abschnitte sich in einem vorbestimmten Bereich der ersten Bitfolge (20, 20') befindet, so dass eine Aufteilung der Folge in Teile mit im Wesentlichen gleicher Länge erfolgt, wobei das erste Mittel (3, 3', 9) einen Test durchführt, um festzustellen, ob sich die aufeinanderfolgenden Bits in jedem dieser Abschnitte in einem gleichen logischen Zustand, "0" oder "1", befinden, und wobei das Mittel an seinem Ausgang (S, S") ein Signal eines ersten logischen vorbestimmten Zustands liefert, wenn der Test positiv ist, und eines zweiten vorbestimmten logischen Zustands liefert, wenn der Test negativ ist, wobei ein zweites Mittel (4) das Ausgangssignal (S, S") des ersten Mittels (3, 3', 9) auf einem ersten Eingang und ein bestimmtes Bit (D) der Abschnitte (CDE) auf einem zweiten Eingang empfängt, so dass es unverändert übertragen wird, wenn der Test negativ ist, und so, dass das Bit invertiert wird, wenn der Test positiv ist, wobei ein drittes Mittel (7) von dem Ausgangssignal gesteuert wird, um die Bits der zweiten Folge auf vorbestimmte logische Konfigurationen zu setzen, in eineindeutiger Relation.

8. Vorrichtung gemäß Anspruch 7, **dadurch gekennzeichnet, dass** mit einer Codierung des sogenannten "8B/10B"-Typs, einer Länge der ersten Folge (20) von 8 Bits, so dass ein Datenbyte (A ... H) geformt wird, dessen aufeinanderfolgenden Positionen von 1 bis 8 durchnummeriert sind, einer Länge der zweiten Folge (21) von 2 Bits (X₁, X₂) und einer Länge des Abschnitts (CDE) von drei Bits, das erste Mittel (3) ein logisches "UND"-Gatter (30) und parallel dazu ein logisches "ODER"-Gatter (31) umfasst, jedes mit drei Eingängen, so dass sie auf jedem ihrer Eingänge eines der 3 Bits des Abschnitts (CDE) empfangen, einschließlich des Bits Nr. 5, und ein logisches "ODER"-Gatter (33) mit zwei Eingängen, das direkt das Ausgangssignal des logischen "UND"-Gatters (30) und über einen Inverter (32) das Ausgangssignal des logischen "ODER"-Gatters (31) empfängt, so dass am Ausgang (S) ein Signal mit dem logischen Zustand "1" abgegeben wird, falls, und nur falls, alle Bits des Abschnitts (CDE) im gleichen logischen Zustand, "0" oder "1", sind, und das zweite Mittel ein logisches "ODER-Exklusiv"-Gatter (4) mit zwei Eingängen ist, das auf einem ersten Eingang das Ausgangssignal (S) des ersten Mittels (3) empfängt und auf einem zweiten Eingang das mittlere Bit (D) des Abschnitts von 3 Bits (CDE), so dass es das Bit unverändert überträgt, wenn der Test negativ ist, und es invertiert, wenn der Test positiv ist, und das dritte Mittel einen Inverter (7) umfasst, der am Eingang das Ausgangssignal (S) des ersten Mittels (3) empfängt, wobei die zweite Folge gebildet ist durch ein erstes Bit (X₁) im gleichen logischen Zustand wie das Signal (S) und ein zweites Bit (X₂) im gleichen logischen Zustand wie das Ausgangssignal des Inverters (7).

9. Vorrichtung gemäß Anspruch 7, **dadurch gekennzeichnet, dass** sie einen Decodierer umfasst mit wenigstens einem Mittel (8) zum Prüfen der Konfiguration der Bits (X₁, X₂) der zweiten Folge, so dass selektiv wenigstens ein Bit (D') der Abschnitte selektiv invertiert wird, wenn vorbestimmte Konfigurationen erkannt werden, die anzeigen, dass dieses Bit bei der Codierung invertiert wurde, und die erste Folge in ihren Ursprungszustand zurückversetzt wird.

10. Vorrichtung gemäß Anspruch 9, **dadurch gekennzeichnet, dass** mit einer Codierung des "8B/10B"-Typs, einer Länge der ersten Folge (20) von 8 Bits, so dass ein Datenbyte geformt wird, dessen aufeinanderfolgenden Positionen von 1 bis 8 durchnummeriert sind, einer Länge der zweiten Folge (21) von 2 Bits und einer Länge des Abschnitts (CDE) von drei Bits, das Mittel (8) zum Prüfen ein logisches "UND"-Gatter (80) umfasst mit einem direkten Eingang (801) und einem invertierenden Eingang (800), wobei die Bits (X₁,X₂) der zweiten Folge zu je einem dieser Eingänge übertragen werden, und ferner ein logisches "ODER-Exklusiv"-Gatter (81) mit zwei Eingängen umfasst, das auf einem ersten Eingang (810) das Ausgangssignal des logischen "UND"-Gatters (80) empfängt und auf einem zweiten Eingang (811) das mittlere Bit (D') des Abschnitts von drei Bits, so dass das Bit unverändert übertragen wird, wenn die logische Konfiguration der zweiten Sequenz "01" ist und es invertiert wird, wenn die logische Konfiguration der zweiten Folge "10" ist.

11. Vorrichtung gemäß Anspruch 9 oder 10, **dadurch gekennzeichnet, dass** sie ein erstes zusätzliches Mittel aufweist zum Erkennen von Fehlern in der Konfiguration der Bits (X₁, X₂) der zweiten Folge (21) durch das Erkennen einer vorbestimmten logischen Konfiguration.

12. Vorrichtung gemäß Anspruch 9 oder 10, **dadurch gekennzeichnet, dass** sie ein zweites zusätzliches Mittel (8a) aufweist, um eine fehlerhafte Konfiguration des Abschnitts (CDE) nach der Decodierung zu erkennen, wenn die logische Konfiguration der Bits (X₁, X₂) der zweiten Folge anzeigt, dass das Bit während der Codierung invertiert wurde, wobei die fehlerhafte Konfiguration auftritt, wenn die drei Bits des Abschnitts im gleichen logischen Zustand sind.
